# EUROPEAN PATENT APPLICATION

(11) **EP 4 579 799 A1**
(43) Date of publication of application: **02.07.2025**
(21) Application number: 23907765.4
(22) Date of filing: 20.12.2023
(51) Int. Cl.: H01M 4/36, H01M 4/525, H01M 4/505, H01M 4/587, H01M 4/38, H01M 10/0587, H01M 10/052, H01M 50/107, H01M 4/02

(54) **LITHIUM SECONDARY BATTERY**

(30) Priority: 23.12.2022 KR 20220183756
(71) Applicant: LG Energy Solution, Ltd., Seoul 07335 (KR)
(72) Inventor: LIM, Seong Min, Daejeon 34122 (KR)
(74) Representative: Goddar, Heinz J.
(86) International application number: PCT/KR2023/021165
(87) International publication number: WO 2024/136482

(57) **Abstract**

The present invention relates to a lithium secondary battery comprising: an electrode assembly comprising a positive electrode comprising a positive electrode active material, a negative electrode comprising a negative electrode active material, and a separator disposed between the positive electrode and the negative electrode; an electrolyte; and a battery case accommodating the electrode assembly and the electrolyte, wherein the positive electrode active material comprises a first lithium nickel-based oxide having at least one of a single particle type composed of one nodule and a pseudo-single particle type which is an aggregate of 30 or less nodules, in 50 wt% or more on the basis of the total weight of the positive electrode active material, and the negative electrode active material is composed of a Si/C composite and a carbon-based negative electrode active material.

## Description

### TECHNICAL FIELD

The present invention relates to a lithium secondary battery and more particularly, to a lithium secondary battery having excellent safety and electrochemical properties.

### BACKGROUND ART

Recently, lithium secondary batteries have been in the spotlight as an energy source for electric vehicles. As the supply of electric vehicles spreads, the demand for lithium secondary batteries that can provide a longer driving range per charge and reduced quick charging time is increasing.

Lithium secondary batteries are generally manufactured by a method including forming an electrode assembly by disposing a separator between a positive electrode including a positive electrode active material composed of a transition metal oxide containing lithium and a negative electrode including a negative electrode active material which is capable of storing lithium ions, inserting the electrode assembly in a battery case, injecting a non-aqueous electrolyte that serves as a medium for transferring lithium ions and sealing. The non-aqueous electrolyte is generally composed of a lithium salt, and an organic solvent which is capable of dissolving the lithium salt. Conventionally, as the negative electrode active material of lithium secondary batteries, carbon-based materials such as natural graphite and artificial graphite have been widely used. However, since the carbon-based negative electrode active materials have a small capacity and a slow reaction rate with lithium, secondary batteries using them have limitations in realizing high capacity and quick charging performance.

Accordingly, attempts are being made to develop lithium secondary batteries using a silicon-based material such as silicon oxide (SiOx, 0<x<2), which has a large theoretical capacity, mixed with a carbon-based negative electrode active material. The silicon-based material has a high theoretical capacity compared to the carbon-based material and has a rapid reaction rate with lithium, and if applying the silicon-based material, there are advantages of improving capacity properties and quick charging performance. However, since the silicon-based material has very low electrical conductivity, its volume rapidly expands during the charging/discharging process, and as particles are broken or electrodes came off due to deterioration, battery performance rapidly decreases to be an obstacle to commercialization.

### DISCLOSURE OF THE INVENTION

### TECHNICAL PROBLEM

The present invention is to solve the above-described defects and to provide a lithium secondary battery having excellent electrochemical performance by including 50 wt% or more of single particles/pseudo-single particles as a positive electrode active material and using a mixture of a SiC composite and a carbon-based negative electrode active material as a negative electrode active material.

### TECHNICAL SOLUTION

According to an embodiment, the present invention provides a lithium secondary battery comprising: an electrode assembly comprising a positive electrode comprising a positive electrode active material, a negative electrode comprising a negative electrode active material, and a separator disposed between the positive electrode and the negative electrode; an electrolyte; and a battery case accommodating the electrode assembly and the electrolyte, wherein the positive electrode active material comprises a first lithium nickel-based oxide having at least one of a single particle type composed of one nodule and a pseudo-single particle type which is an aggregate of 30 or less nodules, in 50 wt% or more on the basis of the total weight of the positive electrode active material, and the negative electrode active material is composed of a Si/C composite and a carbon-based negative electrode active material.

Meanwhile, the positive electrode active material may further comprise a second lithium nickel-based oxide having a secondary particle type which is an aggregate of 40 or more primary particles.

The first lithium nickel-based oxide and the second lithium nickel-based oxide may be each independently represented by [Formula 1] below.

[Formula 1] Li₁₊ₓNiₐCo_{b}M¹_{c}M²_{d}O₂

In Formula 1, M¹ is Mn, Al or a combination thereof, M² comprises one or more selected from the group consisting of W, Zr, Y, Ba, Ca, Ti, Mg, Ta and Nb, 0≤x≤0.5, 0.8≤a<1, 0<b<0.2, 0<c<0.2, and 0≤d≤0.05.

The first lithium nickel-based oxide may have D₅₀ of 3 µm to 10 µm, D₉₀ of 10 µm or less, and D₁₀ of 4 µm or less.

The positive electrode may have a loading density of 5.35 mAh/cm² or more, a porosity of 22% to 25%, and a crack ratio of 30% or less.

Meanwhile, the negative electrode active material may be composed of a Si/C composite and a carbon-based negative electrode active material, and may comprise, for example, Si/C composite: carbon-based negative electrode active material in a weight ratio of 1: 99 - 20: 80.

The Si/C composite may preferably have a grain size of 20 nm or less, and D₅₀ of 1 µm to 10 µm.

The negative electrode may have a loading density of 5.7 mAh/cm² or more, and a porosity of 24% to 30%.

Meanwhile, the negative electrode may comprise a current collector, a first negative electrode active material layer formed on the current collector and a second negative electrode active material layer formed on the first negative electrode active material layer,wherein the first negative electrode active material layer and the second negative electrode active material layer comprise Si/C composites and carbon-based negative electrode active materials as the negative electrode active materials, and the carbon-based negative electrode active materials included in the first negative electrode active material layer and the second negative electrode active material layer are different from each other. For example, the carbon-based negative electrode active material comprised in the first negative electrode active material layer may be natural graphite, and the carbon-based negative electrode active material comprised in the second negative electrode active material layer may be artificial graphite.

The electrode assembly may be a jelly-roll type electrode assembly, and the battery case may be a cylindrical case. In this case, the lithium secondary battery may have a form factor ratio of 0.4 or more.

### ADVANTAGEOUS EFFECTS

The lithium secondary battery according to the present invention uses a mixture of a Si/C composite and a carbon-based negative electrode active material as a negative electrode active material, and may accomplish excellent resistance characteristic and a higher capacity per unit volume compared to the conventional case using a mixture of SiO and a carbon-based negative electrode active material.

In addition, the lithium secondary battery according to the present invention includes single particles and/or pseudo-single particles in 50 wt% or more as a positive electrode active material, and the generation of gas due to particle breakage during forming an electrode and internal crack generation during charging and discharging may be minimized, and excellent safety may be achieved in large-sized batteries having increased volume.

In addition, as in the present invention, if the Si/C composite is used as a silicon-based negative electrode active material, and single particles and/or pseudo-single particles are included in a positive electrode active material, effects of improving lifetime characteristics may be obtained compared to a case using SiO or Si as a silicon-based negative electrode active material.

### BRIEF DESCRIPTION OF DRAWINGS

FIG. 1 is a diagram showing a lamination state before winding an electrode assembly according to the present invention.
FIG. 2 is a cross-sectional view showing the structure of the electrode plate of an electrode assembly according to the present invention.
FIG. 3 is a cross-sectional view showing the structure of a lithium secondary battery according to an embodiment of the present invention.
FIG. 4 is a cross-sectional view showing the structure of a lithium secondary battery according to another embodiment of the present invention.
FIG. 5 is a diagram showing measurement results of the resistance of the electrode layers of lithium secondary batteries manufactured by Examples 1-3 and Comparative Examples 1-2.
FIG. 6 is a diagram showing measurement results of the interface resistance of lithium secondary batteries manufactured by Examples 1-3 and Comparative Examples 1-2.
FIG. 7 is a diagram showing measurement results of the direct current resistance (DCIR) of lithium secondary batteries manufactured by Examples 3-4 and Comparative Examples 5-6.
FIG. 8 is a diagram showing measurement results of the alternating current resistance (ACIR) of lithium secondary batteries manufactured by Examples 3-4 and Comparative Examples 5-6.
FIG. 9 is a SEM photographic image showing the broken state of positive electrode active material particles after rolling a positive electrode manufactured by Example 4.
FIG. 10 is a SEM photographic image showing the broken state of positive electrode active material particles after rolling a positive electrode manufactured by Comparative Example 3.
FIG. 11 is a SEM photographic image showing the broken state of positive electrode active material particles after rolling a positive electrode manufactured by Comparative Example 4.

### BEST MODE FOR CARRYING OUT THE INVENTION

Hereinafter, the present invention will be explained in more detail.

Words or terms used in the present description shall not be interpreted as the meaning defined in commonly used dictionaries. The words or terms should be interpreted as having a meaning that is consistent with the technical idea of the invention, based on the principle that an inventor may properly define the meaning of the words or terms to best explain the invention.

In the present invention, "a single particle" is a particle composed of one single nodule. In the present invention, "a pseudo-single particle" means a composite particle formed by aggregating 30 or less nodules.

In the present invention, "a nodule" means a particle unit body constituting the single particle and the pseudo-single particle, and the nodule may be a single crystal lacking a crystalline grain boundary, or a polycrystal with no apparent grain boundary if observed using a scanning electron microscope (SEM) at a view of 5000 to 20000 times.

In the present invention, "a secondary particle" means a particle formed by aggregating tens to hundreds of multiple primary particles. More particularly, the secondary particle is an aggregate of 40 or more primary particles.

The expression "particle" as used in the present invention may include any or all of a single particle, a pseudo-single particle, a primary particle, a nodule and a secondary particle.

In the present invention, "Dₙ" means a particle diameter at a point where a volume accumulation amount is n% on the volume accumulated particle size distribution of a target powder for measurement. That is, D₁₀ means a particle diameter at a point where the volume accumulation amount is 10%, D₅₀ means a particle diameter at a point where the volume accumulation amount is 50%, and D₉₀ means a particle diameter at a point where the volume accumulation amount is 90%. The Dₙ may be measured by using a laser diffraction method. For example, Dₙ may be measured by dispersing a target powder for measurement (for example, a positive electrode active material powder or a Si/C composite powder) in a dispersion medium, introducing the dispersion into a commercially available laser diffraction particle size measurement apparatus (for example, Microtrac MT 3000), irradiating ultrasonic waves of about 28 kHz with an output of 60W, obtaining a volume accumulated particle size distribution graph, and obtaining a particle diameter at a corresponding volume accumulation using the volume accumulated particle size distribution graph.

In the present invention, a "specific surface area" is measured by a BET method, and may particularly be computed using BELSORP-mino II of BEL Japan Co. from a nitrogen gas absorption amount at a liquid nitrogen temperature (77K).

In the present invention, a "grain size" was measured by analyzing XRD data obtained through X-ray diffraction analysis of a target powder for measurement (that is, Si/C composite powder) by a Rietveld refinement method. In this case, the X-ray diffraction analysis was conducted using Bruker D8 Endeavor equipped with LynxEye XE-T-position sensitive detector (light source: Cu-Kα, A=1.54 Å),by putting a specimen in the groove of a holder for a general powder, making the surface of the sample even using a slide glass, charging the specimen so that the height of the specimen matches the edge of the holder, and measuring under conditions of step size = 0.016, and total scan time = about 1/20 minutes, with respect to FDS 0.5°, and 2θ=10°-90° range. Particularly, during the grain size analysis, instrumental broadening used fundamental parameter approach (FPA) realized by a Bruker TOPAS program, and entire peaks in a measurement range during fitting were used. The fitting of a peak shape was performed using only Lorenzian contribution as a first principle (FP) among peak types used in TOPAS.

In the present invention, a "loading amount (R, unit: g/25 cm²)" was obtained by measuring a weight W1 of an electrode punched to a size of 5 cm x 5 cm, and a weight W2 of an electrode current collector, and substituting them into [Equation 1] below. Electrode loading amount (g/25 cm2) = (W1-W2) /2

In the present invention, a "loading density (unit: mAh/cm²)" was obtained by measuring the total thickness of an electrode Tₜₒₜₐₗ (unit: µm) and the thickness of an electrode current collector T_{c} (unit: µm) using a thickness measurement apparatus of Tesa Co., and substitution the electrode loading amount R (unit: g/25cm²), the total thickness of an electrode Tₜₒₜₐₗ and the thickness of an electrode current collector T_{c} in [Equation 2] below. Loading density (mAh/cm2) = [(R/25) x capacity per unit area of active material]/{ (Ttotal-Tc) x 0.00005}

In the present invention, a "porosity (%) " was obtained by vacuum drying an electrode punched into a size of 5 cm x 5 cm, measuring the total thickness of an electrode T'ₜₒₜₐₗ (unit: µm) and the thickness of an electrode current collector T' _{c} (unit: µm) after vacuum drying, using a thickness measurement apparatus of Tesa Co., substituting the total thickness of an electrode T'ₜₒₜₐₗ, the thickness of an electrode current collector T'_{c} (unit: µm), an electrode loading amount R (unit: g/25 cm²) and an electrode density D (unit: g/cc) into [Equation 3] below. Porosity (%) = (D-R/25) / [D x {(Ttotal - Tc) x 0.00005}]

Hereinafter, the present invention will be explained in more detail.

The inventors of the present invention have conducted repeated research to develop a battery having high energy density and excellent safety and electrochemical properties, and as a result, found that a lithium secondary battery having high energy density and excellent resistance properties could be achieved by including single particles and/or pseudo-single particles in 50 wt% or more, as a positive electrode active material and by using a mixture of a Si/C composite and a carbon-based negative electrode active material, as a negative electrode active material, and completed the present invention.

Particularly, the lithium secondary battery according to the present invention comprises: an electrode assembly comprising a positive electrode comprising a positive electrode active material, a negative electrode comprising a negative electrode active material, and a separator disposed between the positive electrode and the negative electrode; an electrolyte; and a battery case accommodating the electrode assembly and the electrolyte, wherein the positive electrode active material comprises a first lithium nickel-based oxide having at least one of a single particle type composed of one nodule and a pseudo-single particle type which is an aggregate of 30 or less nodules, in 50 wt% or more on the basis of the total weight of the positive electrode active material, and the negative electrode active material is a mixture of a Si/C composite and a carbon-based negative electrode active material.

Hereinafter, each configuration of the lithium secondary battery according to the present invention will be explained in more detail.

### Electrode Assembly

The electrode assembly according to the present invention includes the positive electrode, the separator and the negative electrode. The shape of the electrode assembly is not specifically limited, and may be diverse electrode assemblies, for example, a jelly-roll type, a stack type, a stack and lamination type, or a stack and folding type electrode assembly.

Preferably, the electrode assembly may be a jelly-roll type electrode assembly in which a positive electrode with a sheet type, a negative electrode with a sheet type, and a separator disposed between the positive electrode and the negative electrode are wound in one direction.

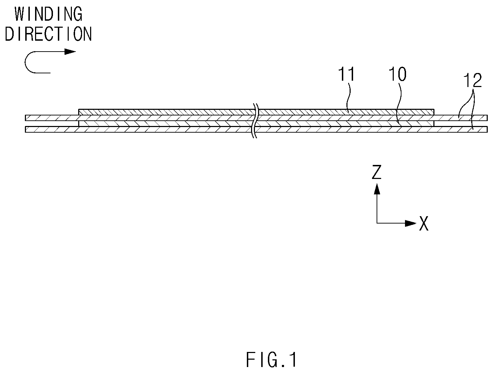

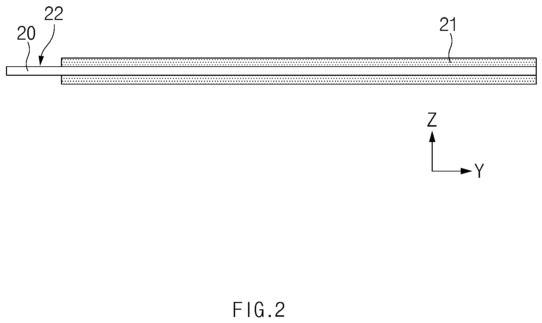

FIG. 1 shows a laminated structure before winding an electrode assembly according to an embodiment of the present invention, and FIG. 2 shows a cross-sectional structure of an electrode (positive electrode or negative electrode) according to an embodiment of the present invention.

Referring to FIG. 1 and FIG. 2, an electrode assembly of the present invention may be manufactured by sequentially laminating a separator (12), a positive electrode (10), a separator (12), and a negative electrode (11) at least once and winding the laminated body in one direction (X).

In this case, as shown in FIG.2, the positive electrode (10) and the negative electrode (11) may have a structure in which an active material layer (21) is formed on a current collector (20) with a sheet shape, and may include a uncoated part (22) on which an active material layer (21) is not formed on a partial area of the current collector (20).

If the positive electrode (10) and the negative electrode (11) include the uncoated part (22), at least a portion of the uncoated part of the positive electrode (10) or the negative electrode (11) may be utilized as an electrode tab instead of providing a separate electrode tab. For example, the uncoated part (22) may be formed long along a winding direction (X) at the end portion of one side of the current collector (20), and by combining the current collector plates with the positive electrode uncoated part and the negative electrode uncoated part, and connecting the current collector plates with electrode terminals, a battery in which an electrode uncoated part defines an electrode tab (tab-less battery for convenience) may be accomplished. The conventional can type battery has a structure in which portions of a positive electrode current collector and a negative electrode current collector are cut and processed to form a positive electrode tab and a negative electrode tab, having a strip shape with a narrow width, and the positive electrode tab and the negative electrode tab are electrically connected with a cap plate and a battery cap. However, in the case of the conventional can type battery having the structure, there are problems in that a current is concentrated on the strip type electrode tab, resulting in high resistance, large heat generation, and poor current collection efficiency. Particularly, during quick charging, this phenomenon is worsened and there is a risk of generating battery ignition or explosion. In contrast, in the case of the tab-less battery using the uncoated parts of the positive electrode plate and the negative electrode plate as electrode tabs as described above, the area through which a current passes increases and current concentration is reduced, thereby effectively reducing heat generation in the battery, and accordingly, achieving the effect of further improving the thermal safety of the battery.

Then, the positive electrode, the negative electrode and the separator constituting the electrode assembly of the present invention will be explained in more detail.

### Positive Electrode

The positive electrode may have a structure in which positive electrode active material layers are formed at one side or both sides of a positive electrode current collector having a sheet shape, and the positive electrode active material layer may include a positive electrode active material and selectively further include a conductive material and a binder.

For example, the positive electrode may be manufactured by a method of preparing a positive electrode slurry by dispersing a positive electrode active material, a conductive material and a binder in a solvent such as dimethyl sulfoxide (DMSO), isopropyl alcohol, N-methylpyrrolidone (NMP), acetone and water, applying the positive electrode slurry on one side or both sides of a positive electrode current collector having a sheet shape, removing the solvent of the positive electrode slurry through a drying process, and rolling. Meanwhile, a positive electrode including a uncoated part may be manufactured by a method of not applying the positive electrode slurry on a partial area of the positive electrode current collector, for example one end of the positive electrode current collector, during applying the positive electrode slurry.

As the positive electrode current collector, various positive electrode current collectors used in this technical field may be used. For example, as the positive electrode current collector, stainless steel, aluminum, nickel, titanium, baked carbon, or aluminum or stainless steel surface treated with carbon, nickel, titanium, silver or the like may be used. The positive electrode current collector may generally have a thickness of 3 µm to 500 µm, and minute irregularities may be formed on the surface of the positive electrode current collector to improve the adhesive strength of the positive electrode active material. The positive electrode current collector may be used in various types such as a film, a sheet, a foil, a net, a porous body, a foamed body, a non-woven fabric and the like.

In the present invention, the positive electrode active material may include a first lithium nickel-based oxide having a single particle type formed of one nodule and/or a pseudo-single particle type which is an aggregate of nodules.

The conventional lithium nickel-based oxide was generally in the form of spherical secondary particles in which tens to hundreds of primary particles are aggregated. However, in the case of the lithium nickel-based oxide of the secondary particle type in which many primary particles are aggregated, there are problems in that particle breakage by which the primary particles are separated, is likely to occur during the rolling process for manufacturing a positive electrode, and cracks occur in the particles during charging and discharging processes. If the particle breakage of the positive electrode active material or cracks in the particle occurs, a contact area with an electrolyte may increase, and there is a problem of increasing the generation of gas due to the side reactions with the electrolyte. If the gas generation increases in the battery, the internal pressure of the battery increases, and there is a risk of arising battery explosion. Particularly, if the volume of the battery increases, the amount of an active material in the battery increases according to the increase of the volume, and as a result, the amount of gas generated increases remarkably, and the risk of battery ignition and/or explosion may further increase.

In contrast, the lithium nickel-based oxide composed of the single particle type composed of one nodule and/or the pseudo-single particle type which is an aggregate of 2-30 nodules has high particle strength compared to the conventional lithium nickel-based oxide of a secondary particle type in which tens to hundreds primary particles are aggregated, and particle breakage during rolling is rarely generated. In addition, in the case of the lithium nickel-based oxide of the single particle and/or pseudo-single particle type, the number of the nodules which are lower particle unit bodies constituting particles is small, and the change according to volume expansion and shrinkage during charging and discharging is small, and accordingly, the generation of cracks in the particle may be markedly reduced. Accordingly, if the lithium nickel-based oxide of the single particle and/or the pseudo-single particle type is included as the positive electrode active material, the amount of gas generated and metal elution due to particle breakage and internal crack generation may be markedly reduced, and accordingly, excellent safety may be accomplished in large-sized batteries.

Meanwhile, the first lithium nickel-based oxide may be included in 50 wt% or more, preferably, 50 wt% to 100 wt% on the basis of the total weight of the positive electrode active material. If the first lithium nickel-based oxide is included in the content less than 50 wt% in the total positive electrode active material, the effect of restraining particle breakage during rolling may be insignificant, and the effect of restraining the amount of gas generated and the elution of a transition metal may not be achieved.

Meanwhile, the first lithium nickel-based oxide may have the average particle size of the nodule of 5 µm or less, 4 µm or less, 3 µm or less, or 2 µm or less, for example, 0.5 µm to 5 µm, preferably, 1 µm to 5 µm, more preferably, 2 µm to 5 µm. If the average particle diameter of the nodule satisfies the above-described range, a positive electrode active material of a single particle and/or pseudo-single particle type having excellent electrochemical properties may be formed. If the average particle diameter of the nodule is too small, the effect of restraining the generation of particle breakage during rolling may be deteriorated, and if the average particle diameter of the nodule is too large, a lithium diffusion path in the particle may become longer, resistance may increase, and output characteristics may be deteriorated.

Meanwhile, in the present invention, the first lithium nickel-based oxide may have D₅₀ of 3 µm to 10 µm, preferably, 3 µm to 8 µm. If the D₅₀ of the first lithium nickel-based oxide is too large, lithium mobility in the positive electrode active material particle may be degraded, and capacity and output properties may be adversely influenced, and if the D₅₀ is too small, the phase stability of the positive electrode slurry may be deteriorated, and coating processability may be deteriorated.

In addition, the first lithium nickel-based oxide may have D₉₀ of 10µm or less, preferably, 5 µm to 10 µm. If the D₉₀ of the first lithium nickel-based oxide is too large, capacity and output properties may be deteriorated.

In addition, the first lithium nickel-based oxide may have D₁₀ of 4 µm or less, preferably, 1 µm to 4 µm. If the D₁₀ of the first lithium nickel-based oxide satisfies the range, thermal stability and electrochemical properties may be more excellent.

Meanwhile, the positive electrode active material may further include a second lithium nickel-based oxide of a secondary particle type in which 40 or more primary particles are aggregated, in addition to the first lithium nickel-based oxide of the single particle and/or pseudo-single particle type, as necessary. If the positive electrode active material of the secondary particle type is additionally included, the improving effect of electrolyte impregnation and rollability may be obtained.

If the positive electrode active material of the secondary particle type is additionally included, the positive electrode active material of the secondary particle type may be included in the content of 50 wt% or less, preferably, 10 to 50 wt%, more preferably, 20 to 50 wt% on the basis of the total weight of the positive electrode active material included in the positive electrode active material layer. If the content of the positive electrode active material of the secondary particle type is too large, the amount of gas generated may increase, and the improving effect of safety may be deteriorated.

Meanwhile, in the present invention, the second lithium nickel-based oxide may have D₅₀ of 8 µm to 20 µm, preferably, 10 µm to 20 µm. If the D₅₀ of the second lithium nickel-based oxide satisfies the range, the packing density of the positive electrode may increase, and energy density may be further improved.

In addition, the second lithium nickel-based oxide may have D₉₀ of 25 µm or less, preferably, 10 µm to 20 µm. If the D₉₀ of the second lithium nickel-based oxide is too large, a problem of degrading rollability during manufacturing an electrode may occur.

In addition, the second lithium nickel-based oxide may have D₁₀ of 7 µm or less, preferably, 2 µm to 6 µm. If the D₁₀ of the second lithium nickel-based oxide satisfies the range, thermal stability and electrochemical properties may be more excellent.

Meanwhile, the first lithium nickel-based oxide and the second lithium nickel-based oxide may have the same or different composition.

Particularly, the first lithium nickel-based oxide and the second lithium nickel-based oxide may each independently include Ni in the content of 80 mol% or more on the basis of the total mole number of the transition metal, for example, from 80 mol% to less than 100 mol%, from 83 mol% to less than 100 mol%, from 85 mol% to less than 100 mol% or from 90 mol% to 98 mol%. If the lithium nickel-based oxide having the high Ni content is used, high capacity may be achieved.

More particularly, the first lithium nickel-based oxide and the second lithium nickel-based oxide may each independently have the composition represented by [Formula 1] below.

[Formula 1] Li₁₊ₓNiₐCo_{b}M¹_{c}M²_{d}O₂

In Formula 1, M¹ is Mn, Al or a combination thereof, preferably, Mn or Mn and Al.

M² may be one or more selected from the group consisting of Zr, W, Y, Ba, Ca, Ti, Mg, Ta and Nb, preferably, one or more selected from the group consisting of Zr, Y, Mg, and Ti, more preferably, Zr, Y or a combination thereof. Element M² does not essential included, but if included in an appropriate amount, it may play the role of promoting grain growth during baking, or improving the stability of a crystal structure.

The 1+x represents a lithium molar ratio in the lithium nickel-based oxide, and 0≤x≤0.5, 0≤x≤0.3, or 0≤x≤0.2 may be satisfied. If the molar ratio of lithium satisfies the range, the crystal structure of the lithium nickel-based oxide may be stably formed.

The a represents the molar ratio of nickel in total metal excluding lithium in the lithium nickel-based oxide, and 0.8≤a<1, 0.83≤a<1, 0.85≤a<1 or 0.90≤a≤0.98 may be satisfied. If the molar ratio of nickel satisfies the range, high energy density may be exhibited, and high capacity may be achieved.

The b represents the molar ratio of cobalt in total metal excluding lithium in the lithium nickel-based oxide, and 0<b<0.2, 0<b<0.17, 0.01≤b≤0.15, or 0.01≤b≤0.10 may be satisfied. If the molar ratio of cobalt satisfies the range, excellent resistance properties and output properties may be achieved.

The c represents the molar ratio of the M¹ element in total metal excluding lithium in the lithium nickel-based oxide, and 0<c<0.2, 0<c<0.17, 0.01≤c≤0.15 or 0.01≤c≤0.10 may be satisfied. If the molar ratio of the M¹ element satisfies the range, the structure stability of the positive electrode active material is excellent.

The d represents the molar ratio of the M² element in total metal excluding lithium in the lithium nickel-based oxide, and 0≤d≤0.05, 0≤d≤0.03, or 0≤d≤0.02 may be satisfied.

Meanwhile, the first lithium nickel-based oxide and the second lithium nickel-based oxide may further include a coating layer including one or more coating elements selected from the group consisting of Al, Ti, W, B, F, P, Mg, Ni, Co, Fe, Cr, V, Cu, Ca, Zn, Zr, Nb, Mo, Sr, Sb, Bi, Si and S, at the surface of the particle as necessary. Preferably, the coating element may be Al, B, Co or combinations thereof. If the coating layer is present at the surface of the lithium nickel-based oxide particle, the contact between an electrolyte and a lithium composite transition metal oxide may be blocked by the coating layer, and due to this, reducing effects of the elution of a transition metal or the generation of gas due to the side reactions with the electrolyte may be obtained.

The positive electrode active material may be included in 80 to 99 wt%, preferably, 85 to 99 wt%, more preferably, 90 to 99 wt% on the basis of the total weight of the positive electrode active material layer.

Meanwhile, the positive electrode may further include a conductive material and/or a binder in addition to the positive electrode active material.

The conductive material is used for improving the conductivity of an electrode, and is not specifically limited as long as it does not induce the chemical change in a constituent battery and has electron conductivity. Particular embodiments may include: graphite such as natural graphite and artificial graphite; carbon-based materials such as carbon black, acetylene black, Ketjen black, channel black, furnace black, lamp black, thermal black, a carbon fiber and carbon nanotube; metal powders or metal fibers of copper, nickel, aluminum, silver or the like; conductive whiskers of zinc oxide, potassium titanate or the like; conductive metal oxides such as titanium oxide; or conductive polymers such as polyphenylene derivatives, and one or a mixture of two or more thereof may be used as the conductive material.

Preferably, the conductive material may include carbon nanotube. Particularly, the conductive material may include single-walled carbon nanotube, multi-walled carbon nanotube or a mixture thereof, and more preferably, single-walled carbon nanotube. The single-walled carbon nanotube is longer than other conductive materials and has a wide coverage. Accordingly, if the single-walled carbon nanotube is included as the conductive material, the amount of the conductive material used may be reduced, the positive electrode active material content may be increased, and it is effective in improving capacity.

The conductive material may be included in 2 wt% or less, 0.01 wt% to 2 wt%, or 0.01 wt% to 1 wt% on the basis of the total weight of the positive electrode active material layer.

Next, the binder may play the role of improving the adhesion among the positive electrode active material particles and the adhesive strength between the positive electrode active material and the positive electrode current collector. Particular embodiments may include polyvinylidene fluoride (PVDF), a polyvinylidene fluoride-hexafluoropropylene copolymer (PVDF-co-HFP), polyvinyl alcohol,polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer rubber (EPDM rubber),a sulfonated EPDM,a styrenebutadiene rubber (SBR),a fluoro rubber, and diverse copolymers thereof, and one or a mixture of two or more thereof may be used. The binder may be included in the content of 1 to 30 wt%, preferably, 1 to 20 wt%, more preferably, 1 to 10 wt% on the basis of the total weight of the positive electrode active material layer.

Meanwhile, the positive electrode may have a loading density of 5.35 mAh/cm² or more, preferably, 5.35 mAh/cm² to 6.0 mAh/cm², more preferably, 5.35 mAh/cm² to 5.80 mAh/cm². If the loading density of the positive electrode satisfies the range, high energy density may be accomplished, and capacity balance may be achieved with a high capacity negative electrode containing a Si/C composite.

In addition, the positive electrode may have a porosity of 22% to 25%, preferably, 22.5% to 25%, more preferably, 22.8% to 24.2%. If the porosity of the positive electrode satisfies the range, excellent capacity and output properties may be shown.

In addition, the positive electrode may have a crack ratio of 30% or less, preferably, 1 to 30%, more preferably, 1 to 20%. If the crack ratio of the positive electrode satisfies the range, the generation of gas and the elution of a metal may be effectively restrained.

### Negative Electrode

The negative electrode may have a structure in which negative electrode active material layers are formed on one side or both sides of a negative electrode current collector having a sheet shape, and the negative electrode active material layer may include a negative electrode active material, a conductive material and a binder.

Particularly, the negative electrode may be manufactured by a method of applying a negative electrode slurry prepared by dispersing a negative electrode active material, a conductive material and a binder in a solvent such as dimethyl sulfoxide (DMSO), isopropyl alcohol, N-methylpyrrolidone (NMP), acetone and water, on one side or both sides of a negative electrode current collector having a sheet shape, removing the solvent of the negative electrode slurry through a drying process, and rolling. Meanwhile, a negative electrode including a uncoated part may be manufactured by a method of not applying the negative electrode slurry on a partial area of the negative electrode current collector, for example, one end of the negative electrode current collector during applying the negative electrode slurry.

In the present invention, the negative electrode active material includes a Si/C composite and a carbon-based negative electrode active material.

In order to increase the capacity of a secondary battery, research and development on lithium secondary batteries using a silicon-based negative electrode active material with high theoretical capacity are actively conducted, and in particular, technologies using silicon oxide as the silicon-based negative electrode active material are being researched. However, in the case of silicon oxide, irreversible capacity is large, and initial efficiency is low below 85%, and thus, there is a limitation to increase capacity. Meanwhile, the Si/C composite is a composite material of carbon and silicon and has high capacity and initial efficiency compared to SiOx. Accordingly, in the present invention, by applying a Si/C composite having a theoretical discharge capacity of 1600 mAh/g or more, which is higher than the discharge capacity of silicon oxide, and an initial efficiency of 85% or more, a lithium secondary battery having excellent energy density compared to the conventional one may be accomplished.

In addition, according to the research by the present inventors, if the Si/C composite is applied as in the present invention, electrode and cell resistance may be lowered compared to a case of applying silicon oxide, and excellent output properties may be achieved. A lithium secondary battery using a single particle/pseudo-single particle positive electrode active material has advantages of excellent safety and lifetime characteristics, but has problems of deteriorated output properties due to high resistance. However, as in the present invention, if the Si/C composite is included as the negative electrode active material, electrode and cell resistance may be lowered, and excellent output properties may be achieved.

The Si/C composite may have a grain size of 20 nm or less, preferably, 1 nm to 20 nm, more preferably, 1 nm to 18 nm. If the grain size of the Si/C composite satisfies the range, the improving effect of cell resistance properties and lifetime characteristics may be excellent.

In addition, the Si/C composite may have D₅₀ of 1 µm to 15 µm, preferably, 2 µm to 10 µm, more preferably, 3 µm to 10 µm. In addition, the Si/C composite may have D₁₀ of 5 µm or less, preferably, 1-5 µm, and D₉₀ of 6 µm to 20 µm, preferably, 6 µm to 15 µm. If the particle size distribution of the Si/C composite satisfies the range, the negative electrode density may increase to accomplish high energy density.

Meanwhile, the carbon-based negative electrode active material may be, for example, artificial graphite, natural graphite, a graphitized carbon fiber, amorphous carbon, soft carbon, hard carbon or the like, preferably, artificial graphite, natural graphite and a combination thereof.

Meanwhile, preferably, the negative electrode active material of the present invention does not contain a silcon-based negative electrode active material other than the Si/C composite (for example, silicon oxide and silicon). If the silcon-based negative electrode active material other than the Si/C composite is included, capacity improving effect may become insignificant, and lifetime characteristics may be deteriorated. More preferably, the negative electrode active material according to the present invention may be formed from the Si/C composite and a carbon-based negative electrode active material.

In the present invention, the negative electrode active material may include SiC/composite: carbon-based negative electrode active material in a weight ratio of 1: 99 to 20: 80, preferably, 1: 99 to 15: 85, more preferably, 4: 96 to 10: 90. If the mixing ratio of the Si/C composite and the carbon-based negative electrode active material satisfies the range, both capacity properties and lifetime characteristics may be excellent.

The negative electrode active material may be included in 80 to 99 wt%, preferably, 85 to 99 wt%, more preferably, 90 to 99 wt% on the basis of the total weight of the negative electrode active material layer.

Meanwhile, as the negative electrode current collector, negative electrode current collectors commonly used in this technical field may be used, for example, copper, stainless steel, aluminum, nickel, titanium, baked carbon, copper or stainless steel, surface treated with carbon, nickel, titanium, silver or the like, an aluminum-cadmium alloy or the like. The negative electrode current collector may commonly have a thickness of 3 µm to 500 µm, and may reinforce the adhesive strength of the negative electrode active material by forming minute irregularities at the surface of the current collector like the positive electrode current collector. For example, various types including a film, a sheet, a foil, a net, a porous body, a foamed body, a non-woven fabric or the like may be used.

The conductive material is used for providing a negative electrode with conductivity, and is not specifically limited as long as it does not induce the chemical change in a constituent battery and has electron conductivity. Particular embodiments may include: graphite such as natural graphite and artificial graphite; carbon-based materials such as carbon black, acetylene black, Ketjen black, channel black, furnace black, lamp black, thermal black, a carbon fiber and carbon nanotube; metal powders or metal fibers of copper, nickel, aluminum, silver or the like; conductive whiskers of zinc oxide, potassium titanate or the like; conductive metal oxides such as titanium oxide;or conductive polymers such as polyphenylene derivatives, and one or a mixture of two or more thereof may be used. The conductive material may be included in the content of 1 to 30 wt%, preferably, 1 to 20 wt%, more preferably, 1 to 10 wt% on the basis of the total weight of the negative electrode active material layer.

The binder may play the role of improving the adhesion among the negative electrode active material particles and the adhesive strength between the negative electrode active material and the negative electrode current collector. Particular embodiments may include polyvinylidene fluoride (PVDF), a polyvinylidene fluoride-hexafluoropropylene copolymer (PVDF-co-HFP), polyvinyl alcohol,polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer rubber (EPDM rubber),a sulfonated EPDM,a styrene-butadiene rubber (SBR),a fluoro rubber, and diverse copolymers thereof, and one or a mixture of two or more thereof may be used. The binder may be included in the content of 1 to 30wt%, preferably, 1 to 20 wt%, more preferably, 1 to 10 wt% on the basis of the total weight of the negative electrode active material layer.

Meanwhile, in the negative electrode, the negative electrode active material layer may have a single layer or a multilayer structure composed of two or more layers. For example, the negative electrode may include a first negative electrode active material layer formed on the negative electrode current collector and a second negative electrode active material layer formed on the first negative electrode active material.

If the negative electrode active material layer has a multilayer structure composed of two or more layers, each layer may have a different type of negative electrode active material, a different type and/or content of binder and/or conductive material.

For example, the first negative electrode active material layer (lower layer) and the second negative electrode active material layer (upper layer) may include a Si/C composite and a carbon-based negative electrode active material as negative electrode active materials, wherein the type of the carbon-based negative electrode active material included in the first negative electrode active material layer and the second negative electrode active material layer may be different. Particularly, the carbon-based negative electrode active material included in the first negative electrode active material layer may be natural graphite, and the carbon-based negative electrode active material included in the second negative electrode active material layer may be artificial graphite. If natural graphite is used as the carbon-based negative electrode active material of the lower layer, effect of improving the adhesive strength with the current collector may be obtained, and if artificial graphite is used as the carbon-based negative electrode active material of the upper layer, a reaction rate with lithium may increase, and effect of improving output properties may be obtained.

Otherwise, the content of the carbon-based negative electrode active material in the first negative electrode active material layer (lower layer) may be high compared to the second negative electrode active material layer (upper layer) in the total negative electrode active material, and the content of the Si/C composite in the second negative electrode active material layer may be high compared to the first negative electrode active material layer in the total negative electrode active material, or the content of the conductive material of the second negative electrode active material layer (upper layer) may be high compared to the first negative electrode active material layer (lower layer). In this way, by forming the negative electrode active material layer in a multilayer structure and varying the composition of each layer, the performance characteristics of a battery may be improved. For example, if the content of the conductive material or the Si/C composite in the upper layer is high compared to the lower layer, effect of improving quick charging performance may be obtained.

Meanwhile, the negative electrode may have a loading density of 5.70 mAh/cm² or more, preferably, 5.70 mAh/cm² to 6.50 mAh/cm², more preferably, 5.70 mAh/cm² to 6.20 mAh/cm². If the negative electrode loading density satisfies the range, high energy density may be accomplished, and capacity balance with respect to the positive electrode (N/P ratio) may be adjusted.

In addition, the negative electrode may have a porosity of 24% to 30%, preferably, 24% to 28%, more preferably, 24.8% to 26.2%. If the porosity of the negative electrode satisfies the range, excellent capacity and output properties may be exhibited.

### Separator

The separator is for separating the negative electrode and the positive electrode and providing the moving passage of lithium ions, and uses any separators used in common lithium secondary batteries, without specific limitation. Particularly, as the separator, a porous polymer film, for example, a porous polymer film formed by polyolefin-based polymers such as an ethylene homopolymer, a propylene homopolymer, an ethylene/butene copolymer, an ethylene/hexene copolymer and an ethylene/methacrylate copolymer, or a laminated structure of two or more thereof may be used. In addition, a common non-woven fabric, for example, a non-woven fabric formed of a high melting point glass fiber, a polyethyleneterephthalate fiber or the like may be used. In addition, a coated separator including a ceramic component or a polymer material for securing heat resistance or mechanical strength may be used.

### Electrolyte

As the electrolyte used in the present invention, diverse electrolytes used in lithium secondary batteries, for example, an organic liquid electrolyte, an inorganic liquid electrolyte, a solid polymer electrolyte, a gel-type polymer electrolyte, a solid inorganic electrolyte, a molten-type inorganic electrolyte, or the like may be used, and the type thereof is not specifically limited.

Particularly, the electrolyte may include an organic solvent and a lithium salt.

The organic solvent may use any one which may play the role of a medium for moving ions involving the electrochemical reaction of a battery, without specific limitation. Particularly, as the organic solvent, ester-based solvents such as methyl acetate, ethyl acetate, γ-butyrolactone, and ε-caprolactone; ether-based solvents such as dibutyl ether and tetrahydrofuran; ketone-based solvents such as cyclohexanone; aromatic hydrocarbon-based solvents such as benzene and fluorobenzene; carbonate-based solvents such as dimethylcarbonate (DMC), diethylcarbonate (DEC), methyl ethyl carbonate (MEC), ethyl methyl carbonate (EMC), ethylene carbonate (EC), and propylene carbonate (PC); alcohol-based solvents such as ethyl alcohol and isopropyl alcohol; nitriles such as R-CN (R is a hydrocarbon group of a linear, branched or cyclic structure having 2 to 20 carbon atoms and may include a double bond, an aromatic ring or an ether bond); amides such as dimethylformamide; dioxolanes such as 1,3-dioxolane; or sulfolanes may be used. Among them, the carbonate-based solvents are preferable, and a mixture of a cyclic carbonate having high ionic conductivity and high dielectricity, which may improve the charging and discharging performance of a battery (for example, ethylene carbonate or propylene carbonate), and a linear carbonate-based compound of a low viscosity (for example, ethyl methyl carbonate, dimethyl carbonate or diethyl carbonate) is more preferable.

The lithium salt may use any compounds that may provide lithium ions used in lithium secondary batteries, without specific limitation. Particularly, the lithium salt may use LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, LiB(C₂O₄)₂ or the like. The concentration of the lithium salt may be in a range of 0.1 to 5.0 M, preferably, 0.1 to 3.0 M. If the concentration of the lithium salt is in the range, the electrolyte may have appropriate conductivity and viscosity so that excellent electrolyte performance may be exhibited, and the lithium ions may move effectively.

Meanwhile, the electrolyte may additionally include an additive in addition to the components for the purpose of improving the lifetime characteristics of batteries, restraining the reduction of battery capacity, and improving the discharging capacity of batteries. For example, the electrolyte may include at least one or more additives selected from the group consisting of a cyclic carbonate-based compound, a carbonate-based compound substituted with halogen, a sultone-based compound, a sulfate-based compound, a phosphate-based compound, a borate-based compound, a nitrile-based compound, a benzene-based compound, an amine-based compound, a silane-based compound and a lithium salt-based compound.

Examples of the cyclic carbonate-based compound may include vinylene carbonate (VC) or vinylethylene carbonate.

Examples of the carbonate-based compound substituted with halogen may include fluoroethylene carbonate.

Examples of the sultone-based compound may include at least one or more compounds selected from the group consisting of 1,3-propane sultone (PS), 1,4-butane sultone, ethene sultone, 1,3-propene sultone (PRS), 1,4-butene sultone and 1-methyl-1,3-propene sultone.

Examples of the sulfate-based compound may include ethylene sulfate (Esa), trimethylene sulfate (TMS), or methyl trimethylene sulfate (MTMS).

Examples of the phosphate-based compound may include one or more compounds selected from the group consisting of lithium difluoro(bisoxalato)phosphate, lithium difluorophosphate, tetramethyl trimethyl silyl phosphate, trimethyl silylphosphite, tris(2,2,2-trifluoroethyl)phosphate and tris(trifluoroethyl)phosphite.

Examples of the borate-based compound may include tetraphenylborate, lithium oxalyldifluoroborate (LiODFB), and lithium bisoxalatoborate (LiB(C2O4)2, LiBOB).

Examples of the nitrile-based compound may include at least one or more compounds selected from the group consisting of succinonitrile, adiponitrile, acetonitrile, propionitrile, butyronitrile, valeronitrile, caprylonitrile, heptanenitrile, cyclopentane carbonitrile, cyclohexane carbonitrile, 2-fluorobenzonitrile, 4-fluorobenzonitrile, difluorobenzonitrile, trifluorobenzonitrile, phenylacetonitrile, 2-fluorophenylacetonitrile and 4-fluorophenylacetonitrile.

Examples of the benzene-based compound may include fluorobenzene, examples of the amine-based compound may include triethanolamine or ethylenediamine, and examples of the silane-based compound may include tetravinylsilane.

The lithium salt-based compound is a compound different from the lithium salt included in the non-aqueous electrolyte, and may include lithium difluorophosphate (LiDFP), LiPO₂F₂ or LiBF₄.

The additive may be included in 0.1 to 10 wt%, preferably, 0.1 to 5wt% on the basis of the total weight of the electrolyte.

### Lithium Secondary Battery

Next, the lithium secondary battery according to the present invention will be explained.

The lithium secondary battery according to the present invention comprises: an electrode assembly comprising a positive electrode, a negative electrode and a separator disposed between the positive electrode and the negative electrode; an electrolyte; and a battery case accommodating the electrode assembly and the electrolyte. Each constituent component of the electrode assembly and the electrolyte are the same as described above, and particular explanation thereon will be omitted.

Meanwhile, the battery case may be a prismatic case, a cylindrical case, a pouch case or the like, used in the relevant technical field and may preferably be a cylindrical case. Particularly, the battery case may be a can-type battery case including a battery can accommodating the electrode assembly and the electrolyte, and a sealing body sealing the open end of the battery can.

Preferably, the lithium secondary battery according to the present invention may be a cylindrical battery including a cylindrical battery case, more preferably, a large-sized cylindrical battery having a form factor ratio (defined as a value obtained by dividing the diameter by the height of a cylindrical battery, i.e., the ratio of diameter (Φ) contrast to height (H)) of 0.4 or more. Here, the form factor means a value representing the diameter and the height of a cylindrical battery.

The cylindrical battery according to the present invention may be, for example, a 46110 cell (diameter of 46 mm, height of 110 mm, form factor ratio of 0.418), a 4875 cell (diameter of 48 mm, height of 75 mm, form factor ratio of 0.640), a 48110 cell (diameter of 48 mm, height of 110 mm, form factor ratio of 0.436), a 4880 cell (diameter of 48 mm, height of 80 mm, form factor ratio of 0.600), or a 4680 cell (diameter of 46 mm, height of 80 mm, form factor ratio of 0.575). In the numerical value indicating the form factor, the first two numbers indicate the diameter of the cell, and the next two or three numbers indicate the height of the cell.

Since the lithium secondary battery according to the present invention includes single particle and/or pseudo-single particle type positive electrode active material, the amount of gas generated may be small, and even in a case having the form factor ratio of 0.4 or more, excellent thermal safety may be accomplished.

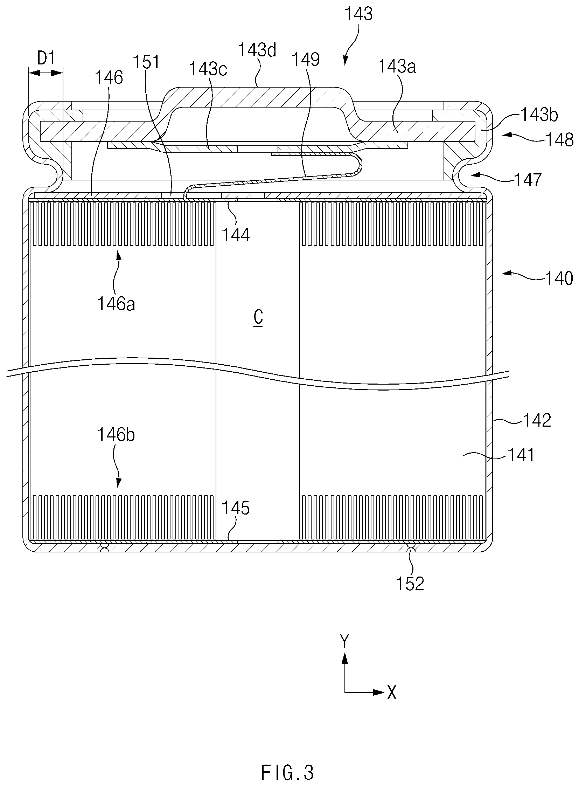

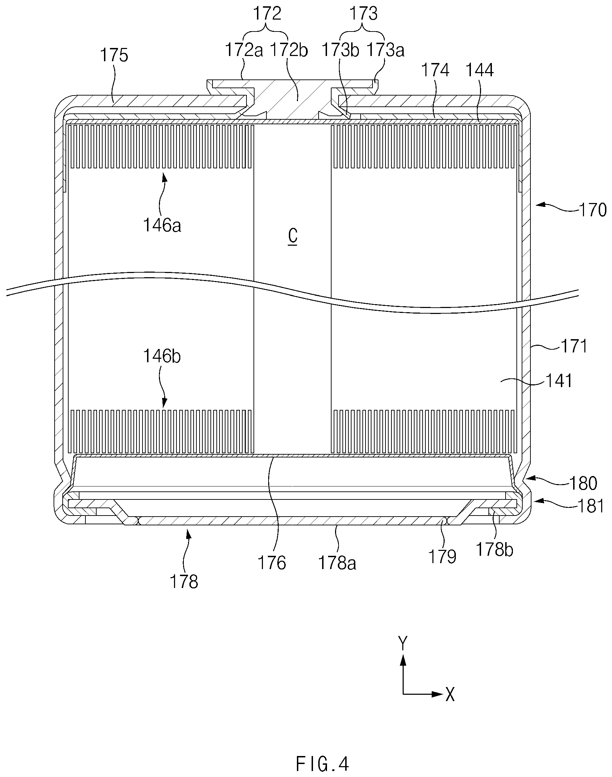

In FIG. 3 and FIG. 4, embodiments of the lithium secondary battery according to the present invention are shown. Hereinafter, the lithium secondary battery according to the present invention will be explained referring to FIG. 3 and FIG. 4. However, FIG. 3 and FIG. 4 show only embodiments of the present invention, and the structure of the battery of the present invention is not limited to the scope shown in FIG. 3 or FIG. 4.

First, referring to FIG. 3, a battery (140) according to an embodiment of the present invention includes an electrode assembly (141), a battery can (142) accommodating the electrode assembly (141) and an electrolyte, and a sealing body (143) sealing the open end of the battery can (142).

The battery can (142) is a container in which an open part is formed at the top, and is made from a metal material having conductivity such as aluminum and steel. The battery can accommodates the electrode assembly (141) in an inner space via the open part at the top and also accommodates the electrolyte together.

The battery can (142) is electrically connected with the uncoated part (146a) of a negative electrode plate and functions as a negative electrode terminal that contacts an external power source and transmits the current applied from the external power source to the negative electrode plate.

If necessary, a beading part (147) and a crimping part (148) may be provided on the top of the battery can (142). The beading part (147) may be formed by pressing the outer circumferential surface of the battery can (142) to a distance of D1. The beading part (147) prevents the electrode assembly (141) accommodated in the battery can (142) from coming out through the top open part of the battery can (142), and may function as a support on which the sealing body (143) is seated.

The crimping part (148) may be formed on the beading part (147) and has an extended and bent shape to surround the outer circumferential surface of a cap plate (143a) disposed on the beading part (147) and a portion of the top surface of the cap plate (143a).

Next, the sealing body (143) is for sealing the open end of the battery can (142), and includes the cap plate (143a), and a first gasket (143b) providing airtightness between the cap plate (143a) and the battery can (142) and providing insulation, and may further include a connection plate (143c) electrically and mechanically coupled to the cap plate (143a), as necessary. The cap plate (143a) may be pressed on the beading part (147) formed on the battery can (142) and may be fixed by the crimping part (148).

The cap plate (143a) is a part formed from a metal material having conductivity and covers the top open part of the battery can (142). The cap plate (143a) is electrically connected with the positive electrode plate of the electrode assembly (141) and electrically insulated from the battery can

(142) through the first gasket (143b). Accordingly, the cap plate (143a) may function as the positive electrode terminal of a secondary battery. The cap plate (143a) may be provided with a protrusion (143d) that protrudes upward from its winding center C, and the protrusion (143d) may be in contact with an external power source to allow current to be applied from the external power source.

Between the cap plate (143a) and the crimping part (148), the first gasket (143b) may be disposed for securing the airtightness of the battery can (142) and electrically insulating between the battery can (142) and the cap plate (143a).

Meanwhile, the battery (140) according to the present invention may further include current collector plates (144, 145) as necessary. The current collector plates are combined with the uncoated part (146a) of a positive electrode plate and the uncoated part (146b) of a negative electrode plate, and connected with electrode terminals (i.e., positive electrode terminal and negative electrode terminal).

Particularly, the battery (140) according to the present invention may include a first current collector plate (144) combined with the top of the electrode assembly (141) and a second current collector plate (145) combined with the bottom of the electrode assembly (141).

The first current collector plate (144) and/or the second current collector plate (145) may be further included.

The first current collector plate (144) is combined at the top of the electrode assembly (141). The first current collector plate (144) is composed of a conductive metal material such as aluminum, copper, and nickel, and is electrically connected with the uncoated part (146a) of the positive electrode plate. To the first current collector plate (144), a lead (149) may be connected. The lead (149) may be extended to the upward of the electrode assembly (141) and combined with the connection plate (143c) or directly combined with the bottom of the cap plate (143a). The combination between the lead (149) and other parts may be achieved through welding. Preferably, the first current collector plate (144) may be integrally formed with the lead (149). In this case, the lead (149) may have a long plate shape extended outward from the center of the first current collector plate (144).

Meanwhile, the first current collector plate (144) may be combined with the end of the uncoated part (146a) of the positive electrode plate, and the combination may be accomplished by a method, for example, laser welding, resistance welding, ultrasonic welding, or soldering.

The second current collector plate (145) is combined at the bottom of the electrode assembly (141). The second current collector plate (145) is formed from a conductive metal material such as aluminum, copper, and nickel and is electrically connected with the uncoated part (146b) of the negative electrode plate. One side of the second current collector plate (145) may be combined with the uncoated part (146b) of the negative electrode plate, and the opposite side may be combined with the inner bottom surface of the battery can (142). In this case, the combination may be accomplished by a method, for example, laser welding, resistance welding, ultrasonic welding, or soldering.

Meanwhile, the battery (140) according to the present invention may further include an insulator (146) as necessary. The insulator (146) may be disposed to cover the top of the first current collector (144). Since the insulator (146) covers the first current collector plate (144), direct contact between the first current collector plate (144) and the inner circumference of the battery can (142) may be blocked.

The insulator (146) is provided with a lead hole (151) through which the lead (149) extending upward from the first current collector plate (144) may be drawn out. The lead (149) may be drawn out upward through the lead hole (151) and combined with the bottom of the connection plate (143c) or the bottom of a cap plate (143a).

The insulator (146) may be formed from a polymer resin, for example, polymer resin materials such as polyethylene, polypropylene, polyimide and polybutyleneterephthalate.

Meanwhile, the battery (140) according to the present invention may further include a venting part (152) formed on the bottom of the battery can (142) as necessary. The venting part (152) corresponds to an area having a thin thickness compared to a surrounding area in the bottom of the battery can (142). Since the venting part (152) is thin, it is structurally weak compared to the surrounding area. Accordingly, if the internal pressure of the battery (140) increases above a certain level, the venting part (152) is burst, and gas inside the battery can (142) is discharged to the outside, and thus, the explosion of the battery may be prevented.

Then, a lithium secondary battery according to another embodiment of the present invention will be explained referring to FIG. 4.

Referring to FIG. 4, a battery (170) according to another embodiment of the present invention has a different structure of a battery can and a sealing body compared to the battery (140) shown in FIG. 3, and the configurations of the electrode assembly and electrolyte are substantially the same.

Particularly, the battery (170) includes a battery can (171) through which a rivet terminal (172) is installed. The rivet terminal (172) is installed on a partially closed closed surface (top in the drawing) of one end of the battery can (171). The rivet terminal (172) is riveted into a through hole (the first opening of a first end) of the battery can (171) with an insulating second gasket (173) disposed therebetween. The rivet terminal (172) is exposed to the outside in a direction opposite to the direction of gravity.

The rivet terminal (172) includes a terminal exposing part (172a) and a terminal inserting part (172b). The terminal exposing part (172a) is exposed to the outside of the closed surface of the battery can (171).The terminal exposing part (172a) may be positioned approximately at the center of the partially closed surface of the battery can (171). The maximum diameter of the terminal exposing part (172a) may be formed larger than the maximum diameter of the through hole formed in the battery can (171). The terminal inserting part (172b) may penetrate approximately the center of the partially closed closed surface of the battery can (171) and be electrically connected with the uncoated part (146a) of a positive electrode plate. The terminal inserting part (172b) may be riveted on the inner surface of the battery can (171). That is, the end of the terminal inserting part (172b) may have a shape curved toward the inner surface of the battery can (171). The maximum diameter of the end of the terminal inserting part (172b) may be larger than the maximum diameter of the through hole of the battery can (171).

The bottom of the terminal inserting part (172b) may be welded with the first current collector plate (144) connected with the uncoated part (146a) of the positive electrode plate. Between the first current collector plate (144) and the inner surface of the battery can (171), an insulation cap (174) formed from an insulating material may be disposed. The insulation cap (174) covers the top of the first current collector plate (144) and the top end edge portion of the electrode assembly (141). Accordingly, the contact of the outer uncoated part of the electrode assembly (141) with the inner surface of the battery can (171) having different polarity, causing a short circuit, may be prevented. The terminal inserting part (172b) of the rivet terminal (172) may penetrate the insulation cap (174) and be welded to the first current collector plate (144).

A second gasket (173) is disposed between the battery can (171) and the rivet terminal (172) to block the electrical contact between the battery can (171) and the rivet terminal (172), having opposite polarities. Accordingly, the top of the battery can (171) having approximately flat shape may function as the positive electrode terminal of the battery (170) .

The second gasket (173) includes a gasket exposing part (173a) and a gasket inserting part (173b). The gasket exposing part (173a) is disposed between the terminal exposing part (172a) of the rivel terminal (172) and the battery can (171). The gasket inserting part (173b) is disposed between the terminal inserting part (172b) of the rivet terminal (172) and the battery can (171). The gasket inserting part (173b) may be deformed together during the riveting of the terminal inserting part (172b) and come into close contact with the inner surface of the battery can (171). The second gasket (173) may be formed from, for example, an insulating polymer resin.

The gasket exposing part (173a) of the second gasket (173) may have an extended shape to cover the outer circumference of the terminal exposing part (172a) of the rivet terminal (172). If the second gasket (173) covers the outer circumference of the rivet terminal (172), the generation of a short circuit in the process of connecting electrical connection parts such as a busbar with the top of the battery can (171) and/or the rivet terminal (172) may be prevented. Though not shown, the gasket exposing part (173a) may have an extended shape to cover a portion of the top of the terminal exposing part (172a) as well as the outer circumference.

In a case where the second gasket (173) is formed from a polymer resin, the second gasket (173) may be combined with the battery can (171) and the rivet terminal (172) by heat fusion. In this case, the airtightness at the bonding interface between the second gasket (173) and the rivet terminal (172) and the bonding interface between the second gasket (173) and the battery can (171) may be reinforced. Meanwhile, if the gasket exposing part (173a) of the second gasket (173) has an extended shape to the top of the terminal exposing part (172a), the rivet terminal (172) may be integrally combined with the second gasket (173) by insert injection.

The remaining area (175) of the top of the battery can (171), excluding the areas occupied by the rivet terminal (172) and the second gasket (173), corresponds to a negative electrode terminal having an opposite polarity to the rivet terminal (172).

A second current collector plate (176) is combined with the bottom of the electrode assembly (141). The second current collector plate (176) is formed from a metal material having conductivity such as aluminum, steel, copper and nickel and is electrically connected with the uncoated part (146b) of a negative electrode plate.

Preferably, the second current collector plate (176) is electrically connected with the battery can (171). For this purpose, at least a portion of the edge portion the second current collector plate (176) may be disposed between the inner surface of the battery can (171) and the first gasket (178b) and fixed. In an embodiment, the at least a portion of the edge portion of the second current collector plate (176) may be fixed at a beading part (180) formed at the bottom of the battery can (171) in a supported state on the bottom surface of the beading part (180), by welding. In a modified embodiment, the at least a portion of the edge portion of the second current collector plate (176) may be directly welded to the inner surface of the battery can (171).

The second current collector plate (176) may be provided with multiple irregularities, radially formed on the opposite surface to the uncoated part (146b). In the case of forming the irregularities, the second current collector plate (176) may be pressed to insert the irregularities into the uncoated part (146b).

Preferably, the second current collector plate (176) and the end of the uncoated part (146b) may be combined by, for example, laser welding.

A sealing body (178) sealing the bottom open end of the battery can (171) includes a cap plate (178a) and a first gasket (178b). The first gasket (178b) electrically separates the cap plate (178a) and the battery can (171). The crimping part (181) fixes the edge of the cap plate (178a) and the first gasket (178b) together. The cap plate (178a) is provided with a vent part (179). The configuration of the vent part (179) is substantially the same as the above-described embodiment.

Preferably, the cap plate (178a) is formed from a metal material having conductivity. However, since the first gasket (178b) is disposed between the cap plate (178a) and the battery can (171), the cap plate (178a) does not exhibit electric polarity. The sealing body (178) functions to seal the open end of the bottom of the battery can (171) and discharge gas if the internal pressure of the battery cell (170) increases above a critical value.

Preferably, the rivet terminal (172) electrically connected with the uncoated part (146a) of the positive electrode plate is used as the positive electrode terminal. In addition, the part (175) excluding the rivet terminal (172) in the top surface of the battery can (171) which is electrically connected with the uncoated part (146b) of the negative electrode plate through the second current collector plate (176) is used as the negative electrode terminal. In this way, if two electrode terminals are positioned at the top of the battery, it is possible to position electrical connection parts such as a busbar only at one side of the battery (170). This may result in the simplification of a battery pact structure and the improvement of energy density. In addition, since the part (175) used as the negative electrode terminal has an approximately flat shape, a sufficient bonding area may be secured for bonding electrical connection parts such as a busbar. Accordingly, the battery (170) may lower the resistance at the bonding portion of the electrical connection parts to a desired level.

The lithium secondary battery of the present invention as above may be used for the manufacture of a battery pack. The battery pack includes an assembly of electrically connected lithium secondary batteries according to the present invention and a pack housing for accommodating the same, and the pack housing may include a busbar for electrically connecting the lithium secondary batteries, a cooling unit, an external terminal or the like. The battery pack may be mounded on a vehicle. The vehicle may be, for example, an electric vehicle, a hybrid vehicle, or a plug-in hybrid vehicle. The vehicle includes a four-wheeled vehicle or a two-wheeled vehicle.

### BEST MODE FOR CARRYING OUT THE INVENTION

Hereinafter, the present invention will be explained in more detail referring to particular embodiments.

### Example 1

### <Manufacture of Positive Electrode>

Positive electrode active material: porous carbon: carbon nanotube: PVDF binder were mixed in a weight ratio of 97.09: 0.6: 0.02 in N-methylpyrrolidone to prepare a positive electrode slurry. In this case, as the positive electrode active material, a mixture of single particles and pseudo-single particles of Li[Ni_{0.93}Co_{0.05}Mn_{0.016}Al_{0.004}]O₂ coated with boron (B) was used.

The positive electrode slurry was applied on one side of an aluminum current collector, dried at 130°C and rolled to manufacture a positive electrode. In this case, the loading density of the positive electrode was 650mg/25cm² (5.40mAh/cm²), the porosity of the positive electrode was 23.5%, and the thickness of the positive electrode was 163 µm.

### <Manufacture of Negative Electrode>

First negative electrode active material: conductive material: binder: carboxymethylcellulose (CMC) were mixed in a weight ratio of 98.04: 0.06: 1: 0.9 in water to prepare a first negative electrode slurry. In this case, a mixture of natural graphite: Si/C composite in a weight ratio of 85: 15 was used as the first negative electrode active material, single-walled CNT was used as the conductive material, and a styrene-butadiene rubber (SBR) was used as the binder.

Then, second negative electrode active material: conductive material: binder: CMC were mixed in a weight ratio of 98.04: 0.06: 1: 0.9 in water to prepare a second negative electrode slurry. In this case, a mixture of artificial graphite: Si/C composite in a weight ratio of 85: 15 was used as the second negative electrode active material, single-walled CNT was used as the conductive material, and SBR was used as the binder.

The first negative electrode slurry and the second negative electrode slurry were sequentially applied on the surface of a copper current collector sheet, dried at 150°C and rolled to manufacture a negative electrode. The loading density of the negative electrode was 283 mg/25cm²(5.94 mAh/cm²), the porosity of the negative electrode was 25.1%, and the thickness of the negative electrode was 143 µm.

### <Manufacture of Lithium Secondary Battery>

By disposing a separator between the positive electrode and the negative electrode thus manufactured, laminating in the order of separator/positive electrode/separator/negative electrode and winding the same, an electrode assembly was manufactured. The electrode assembly thus manufactured was inserted in a cylindrical battery can, an electrolyte was injected, and sealing was performed to manufacture a 4680 cell.

### Example 2

A positive electrode, a negative electrode and a lithium secondary battery were manufactured by the same method as in Example 1 except for using a mixture of natural graphite: Si/C composite in a weight ratio of 91.5: 8.5 as the first negative electrode active material, and a mixture of artificial graphite: Si/C composite in a weight ratio of 91.5: 8.5 as the second negative electrode active material.

### Example 3

A positive electrode, a negative electrode and a lithium secondary battery were manufactured by the same method as in Example 1 except for using a mixture of natural graphite: Si/C composite in a weight ratio of 88.5: 11.5 as the first negative electrode active material, and a mixture of artificial graphite: Si/C composite in a weight ratio of 88.5: 11.5 as the second negative electrode active material.

### Example 4

A positive electrode, a negative electrode and a lithium secondary battery were manufactured by the same method as in Example 3 except for using a mixture of Li[Ni_{0.93}Co_{0.05}Mn_{0.016}Al_{0.004}]O₂ coated with boron (B), in which single particles and pseudo-single particles are mixed, and Li[Ni_{0.89}Co_{0.066}Mn_{0.043}Al_{0.001}]O₂ coated with boron (B) as a secondary particle type in a weight ratio of 50: 50, as the positive electrode active material.

### Comparative Example 1

Positive electrode active material: porous carbon: carbon nanotube: PVDF binder were mixed in a weight ratio of 96.45: 0.6: 0.02 in N-methylpyrrolidone to prepare a positive electrode slurry. In this case, as the positive electrode active material, Li[Ni_{0.93}Co_{0.05}Mn_{0.016}Al_{0.004}]O₂ coated with boron (B), in which single particles and pseudo-single particles are mixed, was used.

The positive electrode slurry was applied on one side of an aluminum current collector, dried at 130°C and rolled to manufacture a positive electrode. The loading density of the positive electrode was 640mg/25cm² (5.29 mAh/cm²), the porosity of the positive electrode was 23.0%, and the thickness of the positive electrode was 162 µm.

### <Manufacture of Negative Electrode>

First negative electrode active material: conductive material: binder: CMC were mixed in a weight ratio of 98.04: 0.06: 1: 0.9 in water to prepare a first negative electrode slurry. In this case, a mixture of natural graphite: SiO in a weight ratio of 85: 15 was used as the first negative electrode active material, single-walled CNT was used as the conductive material, and a styrene-butadiene rubber (SBR) was used as the binder.

Then, second negative electrode active material: conductive material: binder: CMC were mixed in a weight ratio of 98.04: 0.06: 1: 0.9 in water to prepare a second negative electrode slurry. In this case, a mixture of artificial graphite: SiO in a weight ratio of 85: 15 was used as the second negative electrode active material, single-walled CNT was used as the conductive material, and SBR was used as the binder.

The first negative electrode slurry and the second negative electrode slurry were sequentially applied on the surface of a copper current collector sheet, dried at 150°C and rolled to manufacture a negative electrode. The loading density of the negative electrode was 356 mg/25cm² (5.69 mAh/cm²), the porosity of the negative electrode was 25.0%, and the thickness of the negative electrode was 179 µm.

### <Manufacture of Lithium Secondary Battery>

By disposing a separator between the positive electrode and the negative electrode thus manufactured, laminating in the order of separator/positive electrode/separator/negative electrode and winding the same, an electrode assembly was manufactured. The electrode assembly thus manufactured was inserted in a cylindrical battery can, an electrolyte was injected, and sealing was performed to manufacture a 4680 cell.

### Comparative Example 2

A positive electrode, a negative electrode and a lithium secondary battery were manufactured by the same method as in Comparative Example 1 except for preparing a positive electrode slurry by mixing positive electrode active material: porous carbon: carbon nanotube: PVdF binder in a weight ratio of 97.12: 0.6: 0.02 in N-methylpyrrolidone, manufacturing a positive electrode to show the loading density of the positive electrode of 632 mg/25cm² (5.3 mAh/cm²), the porosity of the positive electrode of 23.7%, and the thickness of the positive electrode of 160 µm, and manufacturing a negative electrode to show the loading density of the negative electrode of 396 mg/25cm² (5.94 mAh/cm²), the porosity of the negative electrode of 25.0%, and the thickness of the negative electrode of 189 µm.

### Comparative Example 3

A positive electrode, a negative electrode and a lithium secondary battery were manufactured by the same method as in Example 3 except for preparing a positive electrode slurry by mixing positive electrode active material: porous carbon: carbon nanotube: PVdF binder in a weight ratio of 97.09: 0.4: 0.02 in N-methylpyrrolidone, and using Li[Ni_{0.89}Co_{0.066}Mn_{0.043}Al_{0.001}]O₂ coated with boron (B) in a secondary particle type as the positive electrode active material.

### Comparative Example 4

A positive electrode, a negative electrode and a lithium secondary battery were manufactured by the same method as in Example 3 except for using a mixture of Li[Ni_{0.93}Co_{0.05}Mn_{0.016}Al_{0.004}]O₂ coated with boron (B), in which single particles and pseudo-single particles are mixed, and Li[Ni_{0.89}Co_{0.066}Mn_{0.043}Al_{0.001}]O₂ coated with boron (B) in a secondary particle type in a weight ratio of 30: 70, as the positive electrode active material.

### Comparative Example 5

A positive electrode, a negative electrode and a lithium secondary battery were manufactured by the same method as in Example 1 except for using a mixture of natural graphite: SiO in a weight ratio of 88.5: 11.5 as the first negative electrode active material and a mixture of artificial graphite: SiO in a weight ratio of 88.5: 11.5 as the second negative electrode active material.

### Comparative Example 6

A positive electrode, a negative electrode and a lithium secondary battery were manufactured by the same method as in Example 1 except for using a mixture of natural graphite: SiO: Si/C composite in a weight ratio of 88.5: 9.2: 2.3 as the first negative electrode active material and a mixture of artificial graphite: SiO: Si/C composite in a weight ratio of 88.5: 9.2: 2.3 as the second negative electrode active material.

### Experimental Example 1-Evaluation of Negative Electrode Resistance

The electrode layer resistance of the negative electrode, the interface resistance between the negative electrode current collector and the negative electrode active material layer, and the total sheet resistance of each of the lithium secondary batteries manufactured by Examples 1-3 and Comparative Examples 1-2 were measured with an MP resistor.

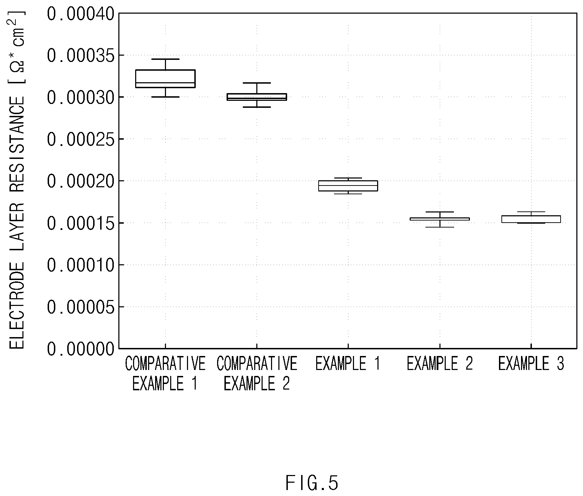

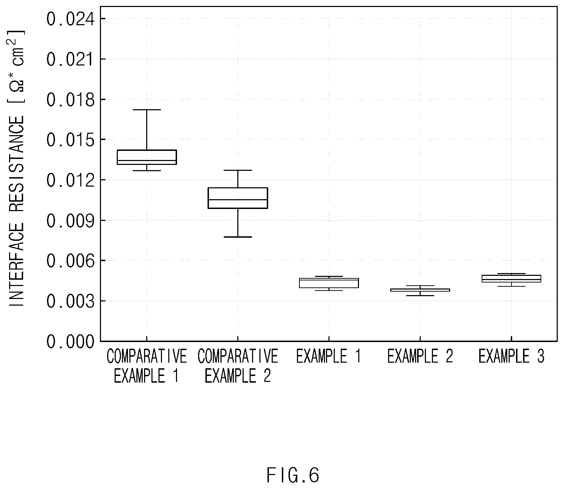

The measurement results are shown in Table 1 below, and FIG. 5 and FIG. 6. FIG. 5 is a graph showing the electrode layer resistances of the lithium secondary batteries manufactured by Examples 1-3 and Comparative Examples 1-2, and FIG. 6 is a graph showing the interface resistances of the lithium secondary batteries manufactured by Examples 1-3 and Comparative Examples 1-2.

**[Table 1]**

| | Electrode layer resistance (Ω·cm²) | Interface resistance (Ω·cm²) | Total sheet resistance (Ω·cm²) |
|---|---|---|---|
| Example 1 | 0.00019 | 0.0044 | 0.00063 |
| Example 2 | 0.00016 | 0.0039 | 0.0054 |
| Example 3 | 0.00015 | 0.0051 | 0.0066 |
| Comparative Example 1 | 0.00032 | 0.0143 | 0.0175 |
| Comparative Example 2 | 0.00030 | 0.0107 | 0.0137 |

Through Table 1 and FIG. 5 to FIG. 6, it can be confirmed that the lithium secondary batteries of Examples 1-3, using the mixture of a Si/C composite and graphite as the negative electrode active material show lower resistance properties compared to the lithium secondary batteries of Comparative Examples 1-2, using the mixture of SiO and graphite as the negative electrode active material.

### Experimental Example 2

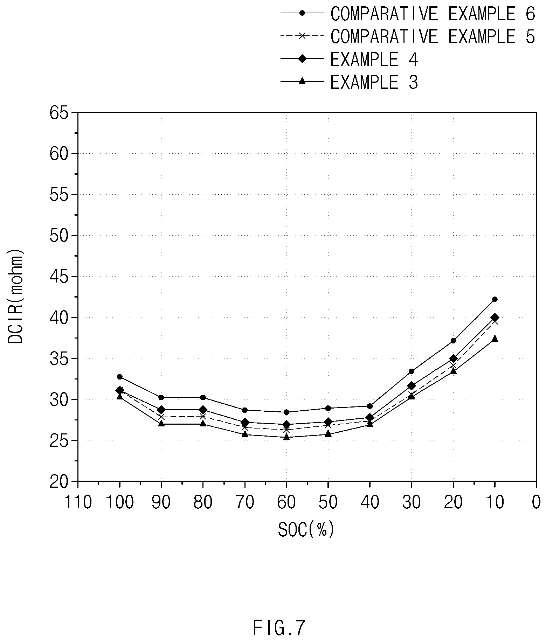

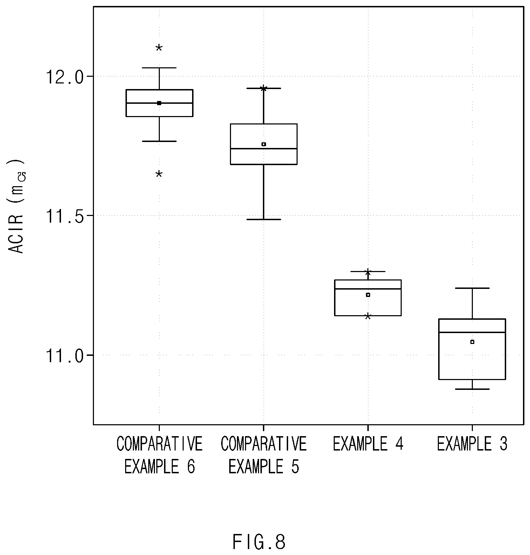

The direct current resistance (DC-IR) and the alternating current resistance (AC-IR) of each of the lithium secondary batteries manufactured by Examples 3-4 and Comparative Examples 5-6 were measured. The measurement results are shown in FIG. 7 and FIG. 8.

Through FIG. 7 and FIG. 8, it can be confirmed that the resistance properties of the lithium secondary batteries of Examples 3 and 4, using the mixture of a Si/C composite and graphite as the negative electrode active material were low compared to Comparative Example 5 using the mixture of SiO and graphite as the negative electrode active material and Comparative Example 6 using the mixture of SiO, a Si/C composite and graphite as the negative electrode active material.

### Experimental Example 3

The porosity (%), rolling ratio (%) and crack ratio (%) of the positive electrodes manufactured in Examples 3-4 and Comparative Examples 3-4 were measured and are shown in [Table 2] below. In this case, the crack ratio (%) was calculated after measuring the cross-sectional SEM image of the positive electrode, as the ratio of an area occupied by cracked particles to the total area of the image measured from the SEM image.

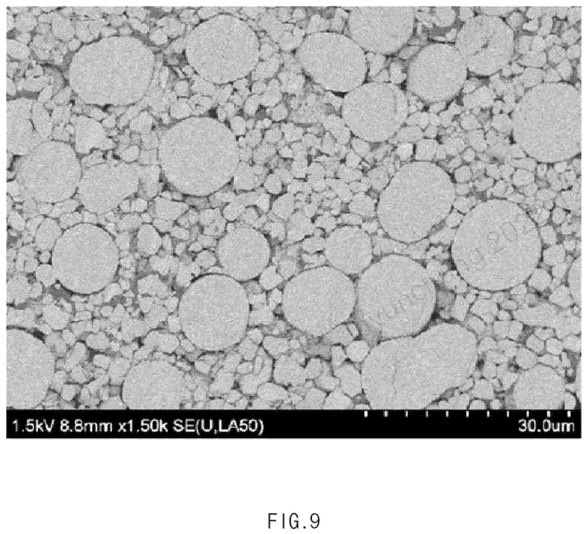

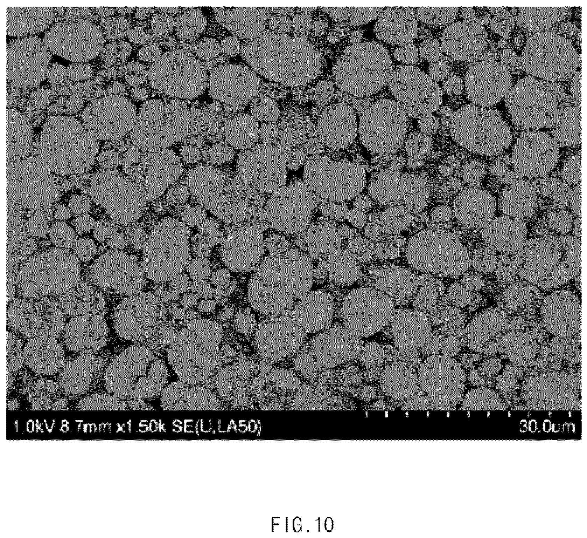

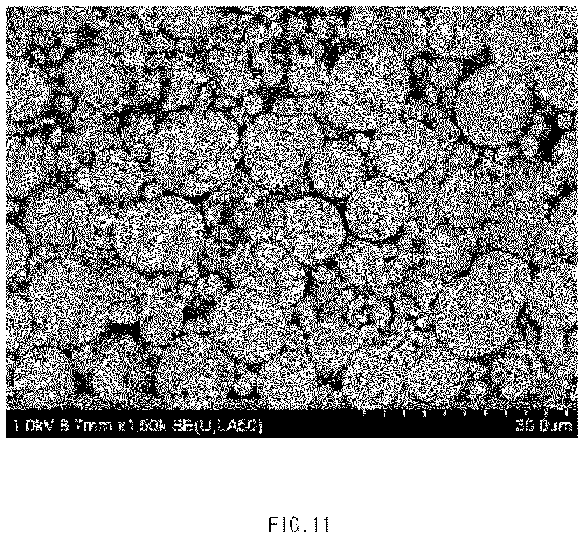

In addition, in FIGS. 9-11, SEM photographic images showing the states after rolling of the positive electrodes manufactured by Example 4, Comparative Example 3 and Comparative Example 4 are shown.

**[Table 2]**

| | Example 3 | Example 4 | Comparative Example 3 | Comparative Example 4 |
|---|---|---|---|---|
| Weight ratio of secondary particles: single particles/pseudo-single particles | 0: 100 | 50: 50 | 100: 0 | 70: 30 |
| Porosity (%) | 23.5 | 24.2 | 24.0 | 24.5 |
| Rolling ratio (%) | 32.1 | 32.3 | 32.6 | 32.8 |
| Crack ratio (%) | 7.6 | 7.8 | 40.6 | 37.4 |

Through [Table 2] and FIGS. 9-11, it can be confirmed that the particle crack ratios were markedly reduced in cases in which the weight ratio of the single particles in the total positive electrode active material was 50% or more(Examples 3 and 4).

### Experimental Example 4-Amount of Gas Generated

After storing the lithium secondary batteries manufactured by Examples 3-4 and Comparative Example 4 at 72°C for 3 days, the amount of gas generated was measured using gas chromatography. The measurement results are shown in Table 3 below.

**[Table 3]**

| | Example 3 | Example 4 | Comparative Example 4 |
|---|---|---|---|
| H₂ | 0.5 | 0.8 | 0.7 |
| CO | 3.4 | 5.1 | 8.1 |
| CO₂ | 1.3 | 4.4 | 9.0 |
| CH₄ | 18.0 | 14.0 | 15.0 |
| C₂H₂ | <0.1 | <0.1 | <0.1 |
| C₂H₄ | 0.1 | 0.1 | 0.1 |
| C₂H₆ | 0.3 | 0.3 | 0.3 |
| C₃H₆ | <0.1 | <0.1 | <0.1 |
| C₃H_{B} | <0.1 | <0.1 | <0.1 |
| Total (ml) | 23.7 | 23.8 | 32.4 |

Through [Table 3], it can be confirmed that the amount of gas generated was reduced according to the increase of the content of single particles/pseudo-single particles in the positive electrode active material.

### Experimental Example 5 - Amount of Metal Eluted

The lithium secondary batteries manufactured by Examples 3-4 and Comparative Example 4 were charged at 72°C with 0.2 C to 4.2 V, and activated by discharging with 0.2 C to 2.5 V, and then, stored at 80°C for 1 day. Immediately after the activation, and after storing at 80°C, the lithium secondary batteries were decomposed, the negative electrodes were recollected, and the eluted amounts of metal attached on the surface of the negative electrodes were measured using ICP-OES (Avio 550 MAX, Perkinelme) apparatus. The measurement results are shown in [Table 4] below.

**[Table 4]**

| Division | Measurement point | Amount of metal eluted (mg/kg) | | | | | | |
|---|---|---|---|---|---|---|---|---|
| | | Ni | Co | Mn | Al | Zr | B | Total |
| Example 3 | After activation | 3 | <1 | 7 | 2 | 2 | <1 | 16 |
| | After storing at high temperature | 14 | <1 | 8 | 2 | 3 | 4 | 32 |
| Example 4 | After activation | 7 | <1 | 4 | 2 | 4 | 3 | 21 |
| | After storing at high temperature | 19 | <1 | 12 | 2 | 4 | 5 | 43 |
| Comparative Example 4 | After activation | 9 | <1 | 5 | 3 | 2 | 9 | 29 |
| | After storing at high temperature | 40 | <1 | 11 | 3 | 3 | 75 | 133 |

As shown in Table 4, in the cases of Example 3 and Example 4, in which the content of single particles in the positive electrode active material was 50 wt% or more, the increasing ratio of the amount of metal eluted after storing at high temperature to that after activation was a level of 100%-105%.On the contrary, in the case of Comparative Example 4, in which the content of single particles in the positive electrode active material was 30 wt%, the increase of the amount of metal eluted after storing at high temperature to that after activation was 358% and very high compared to Examples 3 and 4.

### Experimental Example 6 - Evaluation of Lifetime

The lithium secondary batteries manufactured by Example 3, Comparative Example 5 and Comparative Example 6 were charged with 0.2 C to 4.25 V, and discharged with 0.2 C to 2.5 V as one cycle, the charging and discharging were repeated, and capacity retention ratios (%) and resistance increase rates (%) were measured after 100 cycles, 200 cycles and 300 cycles. The measurement results are shown in [Table 5] below.

**[Table 5]**

| | Example 3 | | Comparative Example 5 | | Comparative Example 6 | |
|---|---|---|---|---|---|---|
| | Capacity retentio n ratio (%) | Resistan ce increas e rate (%) | Capacity retentio n ratio (%) | Resistan ceincre ase rate (%) | Capacity retentio n ratio (%) | Resistan ceincre ase rate (%) |
| Initial | 100 | 0 | 100 | 0 | 100 | 0 |
| 100 cycles | 96.7 | 13.3 | 95.1 | 23.6 | 92.9 | 51.8 |
| 200 cycles | 95.2 | 23.4 | 91.5 | 55.8 | 87.6 | 83.6 |
| 300 cycles | 93.2 | 34.4 | 88.0 | 97.7 | 84.5 | 109.9 |

Through [Table 5], it can be confirmed that the lithium secondary battery of Example 3 has excellent lifetime characteristics compared to the lithium secondary batteries of Comparative Examples 5 and 6.

## Claims

1. A lithium secondary battery comprising: an electrode assembly comprising a positive electrode comprising a positive electrode active material, a negative electrode comprising a negative electrode active material, and a separator disposed between the positive electrode and the negative electrode; an electrolyte; and a battery case accommodating the electrode assembly and the electrolyte,
wherein the positive electrode active material comprises a first lithium nickel-based oxide having at least one of a single particle type composed of one nodule and a pseudo-single particle type which is an aggregate of 30 or less nodules, in 50 wt% or more on the basis of the total weight of the positive electrode active material, and
the negative electrode active material is composed of a Si/C composite and a carbon-based negative electrode active material.

2. The lithium secondary battery according to claim 1, wherein the positive electrode active material further comprises a second lithium nickel-based oxide having a secondary particle type which is an aggregate of 40 or more primary particles.

3. The lithium secondary battery according to claim 1 or 2, wherein the first lithium nickel-based oxide and the second lithium nickel-based oxide are each independently represented by the following [Formula 1]:
[Formula 1] Li₁₊ₓNiₐCo_{b}M¹_{c}M²_{d}O₂
in Formula 1, M¹ is Mn, Al or a combination thereof, M² comprises one or more selected from the group consisting of W, Zr, Y, Ba, Ca, Ti, Mg, Ta and Nb, 0≤x≤0.5, 0.8≤a<1, 0<b<0.2, 0<c<0.2, and 0≤d≤0.05.

4. The lithium secondary battery according to claim 1, wherein the first lithium nickel-based oxide has D₅₀ of 3 µm to 10 µm.

5. The lithium secondary battery according to claim 1, wherein the first lithium nickel-based oxide has D₉₀ of 10 µm or less, and D₁₀ of 4 µm or less.

6. The lithium secondary battery according to claim 1, wherein the positive electrode has a loading density of 5.35mAh/cm² or more.

7. The lithium secondary battery according to claim 1, wherein the positive electrode has a porosity of 22% to 25%.

8. The lithium secondary battery according to claim 1, wherein the positive electrode has a crack ratio of 30% or less.

9. The lithium secondary battery according to claim 1, wherein the negative electrode active material comprises Si/C composite: carbon-based negative electrode active material in a weight ratio of 1: 99 - 20: 80.

10. The lithium secondary battery according to claim 1, wherein the Si/C composite has a grain size of 20 nm or less.

11. The lithium secondary battery according to claim 1, wherein the Si/C composite has D₅₀ of 1 µm to 10 µm.

12. The lithium secondary battery according to claim 1, wherein the negative electrode has a loading density of 5.7mAh/cm² or more.

13. The lithium secondary battery according to claim 1, wherein the negative electrode has a porosity of 24% to 30%.

14. The lithium secondary battery according to claim 1, wherein the negative electrode comprises a current collector, a first negative electrode active material layer formed on the current collector and a second negative electrode active material layer formed on the first negative electrode active material layer,
wherein the first negative electrode active material layer and the second negative electrode active material layer comprise Si/C composites and carbon-based negative electrode active materials as the negative electrode active materials, and the carbon-based negative electrode active materials included in the first negative electrode active material layer and the second negative electrode active material layer are different from each other.

15. The lithium secondary battery according to claim 14, wherein
the carbon-based negative electrode active material comprised in the first negative electrode active material layer is natural graphite, and
the carbon-based negative electrode active material comprised in the second negative electrode active material layer is artificial graphite.

16. The lithium secondary battery according to claim 1, wherein the electrode assembly is a jelly-roll type electrode assembly.

17. The lithium secondary battery according to claim 1, wherein the battery case is a cylindrical case.

18. The lithium secondary battery according to claim 17, wherein the lithium secondary battery has a form factor ratio of 0.4 or more.
